(19) Europäisches Patentamt
European Patent Office
Office européen des brevets

(11) EP 4 112 291 A1

(12) # EUROPEAN PATENT APPLICATION
published in accordance with Art. 153(4) EPC

(43) Date of publication:
**04.01.2023 Bulletin 2023/01**

(21) Application number: **21759983.6**

(22) Date of filing: **19.02.2021**

(51) International Patent Classification (IPC):
***B32B 5/10*** (2006.01) ***B32B 27/32*** (2006.01)
***C08F 8/04*** (2006.01) ***C08F 8/46*** (2006.01)
***C08F 297/04*** (2006.01) ***C08K 7/14*** (2006.01)
***C08L 23/00*** (2006.01) ***C08L 53/02*** (2006.01)
***C08L 67/03*** (2006.01) ***C08L 69/00*** (2006.01)
***C08L 81/06*** (2006.01) ***C08J 5/18*** (2006.01)
***B32B 15/08*** (2006.01) ***B32B 7/025*** (2019.01)
***H05K 1/03*** (2006.01)

(52) Cooperative Patent Classification (CPC):
**B32B 5/10; B32B 7/025; B32B 15/08; B32B 27/32; C08F 8/04; C08F 8/46; C08F 297/04; C08J 5/18; C08K 7/14; C08L 23/00; C08L 53/02; C08L 67/03; C08L 69/00; C08L 81/06; H05K 1/03**

(86) International application number:
**PCT/JP2021/006316**

(87) International publication number:
**WO 2021/172192 (02.09.2021 Gazette 2021/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.02.2020 JP 2020031586**
**21.07.2020 JP 2020124407**
**31.07.2020 JP 2020130157**
**03.08.2020 JP 2020131527**

(71) Applicant: **MCPP Innovation LLC**
**Tokyo 100-8251 (JP)**

(72) Inventors:
- **HAYAKAWA, Yuuko**
**Tokyo 100-8251 (JP)**
- **ISHIHARA, Toshihisa**
**Tokyo 100-8251 (JP)**
- **SANO, Jiro**
**Tokyo 100-8251 (JP)**

(74) Representative: **Hoffmann Eitle**
**Patent- und Rechtsanwälte PartmbB**
**Arabellastraße 30**
**81925 München (DE)**

(54) **RESIN SHEET AND CIRCUIT BOARD MATERIAL USING SAME**

(57) The present invention aims to provide a resin sheet having low dielectric properties, and a circuit board material using the same. From one aspect of the invention, the resin sheet includes at least a resin layer (A) containing a cyclic polyolefin resin copolymer having a crystal melting peak temperature of less than 100°C, the resin sheet having a dielectric loss tangent at 12 GHz of less than 0.005.

EP 4 112 291 A1

## Description

TECHNICAL FIELD

The present invention relates to a resin sheet with low dielectric properties and a circuit board material using the same

Circuit board materials ordinarily used for electric and electronic devices include, mainly, copper-clad laminates (CCL), which are formed by applying a copper foil on the surface of an insulating board obtained by superposing a resin-impregnated sheet (prepreg) on a substrate such as paper or glass, and subjecting them to pressure and heat treatment; and flexible printed circuit boards (FPC), which are obtained by forming an insulating adhesive layer on a base film, and bonding thereon a conductive foil such as a copper foil.

Today's electric and electronic devices use higher transmission frequencies to transmit larger amounts of information at higher rates. Amid this trend, an increase in transmission loss ($\alpha$) is becoming a big problem. A lower transmission loss ($\alpha$) means a lower decay of information signals, and thus higher reliability of communication.

Because the transmission loss ($\alpha$) is proportional to the frequency (f), $\alpha$ tends to be higher during communication in the high frequency range, and this deteriorates reliability of communication. One way to keep the transmission loss ($\alpha$) at a low level is to reduce the dielectric loss tangent (tan $\delta$), to which, as with the frequency (f), $\alpha$ is proportional. For high-speed transmission of communication signals, a material having a low dielectric loss tangent, namely having low dielectric properties, is required.

Examples of materials having low dielectric properties are shown in the below-identified Patent Document 1. They are a composition, a laminate, and a metal-clad laminate which have a polyimide having a specific structure and a bisimide compound having a specific structure, and which have low dielectric properties.

PRIOR ART DOCUMENT

PATENT DOCUMENT

Patent Document 1: JP2001-006437A

SUMMARY OF THE INVENTION

OBJECT OF THE INVENTION

An object of the present invention is to provide a resin sheet having low dielectric properties, and a circuit board material using the same.

After diligent research and careful consideration, the inventors of the present invention discovered that a resin sheet containing a specific cyclic polyolefin resin copolymer should achieve the above object.

In particular, the present invention is characterized by the following features.

[1] A resin sheet comprising at least a resin layer (A) containing a cyclic polyolefin resin copolymer having a crystal melting peak temperature of less than 100°C, the resin sheet having a dielectric loss tangent at 12 GHz of less than 0.005.

[2] The resin sheet of item [1] above, wherein the cyclic polyolefin resin copolymer has cyclohexane at a side chain of the polyolefin.

[3] The resin sheet of item [1] or [2] above, wherein the cyclic polyolefin resin copolymer is either: (i) a resin copolymer containing at least one hydrogenated aromatic vinyl polymer block unit, and at least one hydrogenated conjugated diene polymer block unit, or (ii) a modified copolymer obtained by modifying said resin copolymer with one or both of an unsaturated carboxylic acid and an anhydride of the unsaturated carboxylic acid.

[4] The resin sheet of item [3] above, wherein the hydrogenated aromatic vinyl polymer block unit has a hydrogenation level of 90% or more.

[5] The resin sheet of item [3] or [4] above, wherein the hydrogenated conjugated diene polymer block unit has a hydrogenation level of 95% or more.

[6] The resin sheet of any of items [1]-[5] above, wherein the resin layer (A) contains at least one thermoplastic resin (b) selected from the group consisting of an ethylene-based polymer, an olefin-based thermoplastic elastomer, and a styrene-based thermoplastic elastomer.

[7] The resin sheet of item [6] above, wherein the resin sheet has a storage elastic modulus of less than 2000 MPa at 24°C.

[8] The resin sheet of any of items [1]-[5] above, wherein the resin layer (A) is a composite including a glass cloth (C).

[9] The resin sheet of any of items [1]-[5] above, wherein the resin sheet is a laminate including the resin layer (A) and a glass cloth (C).

[10] The resin sheet of items [8] or [9] above, wherein the glass cloth (C) has a dielectric loss tangent of less than 0.005 at 10 GHz.

[11] The resin sheet of any of items [1]-[5] above, wherein the resin sheet is a laminate including said resin layer (A), and an additional resin layer (D) containing an amorphous resin (d) having a glass transition point of 100°C or more, and a dielectric loss tangent of less than 0.02 at 12GHz.

[12] The resin sheet of item [11] above, wherein the amorphous resin (d) comprises at least one of the resins selected from the group consisting of an alicyclic olefin polymer, a polycarbonate, a polyarylate, a polysulfone, and a copolymer thereof.

[13] The resin sheet of item [11] or [12] above, wherein the resin layer (A) forms at least one of two outermost layers of the resin sheet.

[14] The resin sheet of any of items 1-13, which is used for a circuit board.

[15] A circuit board material comprising the resin sheet of any of claims 1-13, and a conductor laminated on the resin sheet.

ADVANTAGE OF THE INVENTION

The present invention provides a resin sheet having low dielectric properties, and a circuit board material using the same.

EMBODIMENT

The present invention is now described in a detailed manner. It is, however, to be understood that the following description is regarding only one of a number of possible embodiments of the present invention, and the present invention is not limited to what is disclosed below, and covers every modification within the meaning of the present invention.

Any dash (-) used hereinbelow means that the range defined by the dash includes the numerical or physical property values before and after the dash.

The resin sheet according to the present invention at least includes a resin layer (A) containing a cyclic polyolefin resin copolymer having a crystal melting peak temperature of less than 100°C.

<<Resin layer (A)>>

The resin layer (A) of the present invention contains a cyclic polyolefin resin copolymer having a crystal melting peak temperature of less than 100°C. From the viewpoint of low dielectric properties, the cyclic polyolefin resin copolymer preferably constitutes the main component resin of the resin layer (A), and its content, relative to the total amount of the resin components constituting the resin layer (A), is preferably 50% by mass or more, more preferably 60% by mass or more, still more preferably 70% by mass or more, and still further preferably 80% by mass or more. There is no upper limit to this content. In other words, the cyclic polyolefin resin copolymer may be the only resin component of the resin layer (A) (100% by mass).

<Cyclic polyolefin resin copolymer>

The term "cyclic" of the cyclic polyolefin resin copolymer of the present invention refers to an alicyclic structure which the cyclic polyolefin resin copolymer has, specifically, an alicyclic structure which a side chain of the polyolefin has. Suitable examples of such alicyclic structures include cycloalkanes, bicycloalkane and polycyclic compounds. Among them, a cycloalkane is preferable, and cyclohexane is particularly preferable.

The alicyclic structure is preferably an alicyclic structure which the below-described hydrogenated aromatic vinyl polymer blocks have, and which is generated by hydrogenating an aromatic ring.

(Physical properties of the cyclic polyolefin resin copolymer)

The cyclic polyolefin resin copolymer has a crystal melting peak temperature of less than 100°C.

The crystal melting peak temperature of the cyclic polyolefin resin copolymer according to the present invention is preferably 50°C or more, more preferably 60°C or more, and further preferably 65°C or more. On the other hand, the crystal melting peak temperature is preferably 90°C or less, and more preferably 85°C or less.

According to the present invention, the crystal melting peak temperature refers to the temperature at which a crystal melting peak is detected by differential scanning calorimetry (DSC) in which measurement is made at a heating

rate of 10°C/minute. The cyclic polyolefin resin copolymer of the present invention needs to have a crystal melting peak at less than 100°C, and may have an additional crystal melting peak or peaks. For example, two crystal melting peaks may be present, one at less than 100°C, and the other at 100°C or more.

Known cyclic polyolefins include hydrogenated, open-ringed polymers having repeating units derived from monocyclic or polycyclic norbornene-based monomers (such as disclosed in International Publication No. 2012/046443 and International Publication No. 2012/033076). However, these cyclic polyolefins have an alicyclic structure at the main chain of the polymer, and have no crystal melting peak temperature of less than 100°C, or are amorphous.

On the other hand, because the cyclic polyolefin resin copolymer of the present invention has an alicyclic structure at a side chain of the polyolefin, it has a crystal melting peak temperature of less than 100°C.

The dielectric loss tangent of the cyclic polyolefin resin copolymer according to the present invention is, at 12 GHz, preferably less than 0.005, and more preferably less than 0.001. Since the smaller the dielectric loss tangent, the lower the dielectric loss, this value is preferably as small as possible for improved transmission efficiency and speed of electric signals when the resin sheet is used as a circuit board material. The lower limit of the dielectric loss tangent is not particularly limited unless it is less than zero.

The melt flow rate (MFR) of the cyclic polyolefin resin copolymer of the present invention is not particularly limited, but is ordinarily 0.1 g/10 minutes or more, and preferably, from the viewpoint of the forming method and the appearance of the formed member, 0.5 g/10 minutes or more. On the other hand, the MFR is ordinarily 20.0 g/10 minutes or less, and from the viewpoint of the strength of the material, preferably 10.0 g/10 minutes or less, and more preferably 5.0 g/10 minutes or less. By limiting the MFR within any of the above-described ranges, good compatibility with the below-described thermoplastic resin is expected.

MFR is measured, under ISO R1133, at 230°C under the measurement load of 2.16 kg.

<Cyclic polyolefin (a)>

The cyclic polyolefin resin copolymer of the present invention is preferably, for low dielectric properties, (i) a cyclic polyolefin containing at least one hydrogenated aromatic vinyl polymer block unit, and at least one hydrogenated conjugated diene polymer block unit (this cyclic polyolefin is hereinafter also sometimes referred to as the "cyclic polyolefin (a)"), or (ii) a modified cyclic olefin obtained by modifying the cyclic polyolefin (a) with an unsaturated carboxylic acid and/or its anhydride (this modified cyclic olefin is hereinafter also sometimes referred to as the "modified cyclic olefin (a')").

As used herein, the word "blocks" refers to polymer segments of the copolymer which are different in structure or composition from each other, and between which microphase separation is present. Microphase separation occurs due to the polymer segments of a block copolymer not being mixed together.

Microphase separation and block copolymers are discussed extensively in "PHYSICS TODAY" of February 1999 under the subtitle of "Block Copolymers-Designer Soft Materials" (pages 32-38).

The cyclic polyolefin (a) may be, for example, a diblock copolymer composed of a hydrogenated aromatic vinyl polymer block unit (hereinafter referred to as "block A"), and a hydrogenated conjugated diene polymer block unit (hereinafter referred to as "block B"), or may be a triblock, tetrablock or pentablock copolymer, i.e., a copolymer which includes at least two blocks A and/or at least two blocks B. Preferably, the cyclic polyolefin (a) includes at least two blocks A. For example, type A-B-A, type A-B-A-B, or type A-B-A-B-A is preferable.

The cyclic polyolefin (a) preferably includes, at each terminal end thereof, a segment composed of an aromatic vinyl polymer. Thus, the cyclic polyolefin of the present invention preferably has at least two hydrogenated aromatic vinyl polymer block units (blocks A), and at least one hydrogenated conjugated diene polymer block unit (block B) between the two hydrogenated aromatic vinyl polymer block units (blocks A). Thus, the cyclic polyolefin (a) is more preferably type A-B-A or type A-B-A-B-A.

The content of the hydrogenated aromatic vinyl polymer block unit(s) (block(s) A) in the cyclic polyolefin (a) is preferably 30-99 mole %, and more preferably 40-90 mole %. Of these ranges, 50 mole % or more is further preferable, and 60 mole % or more is still further preferable.

By adjusting the content of the hydrogenated aromatic vinyl polymer block unit(s) (block(s) A) to a value equal to or higher than the lower limit of any of the above ranges, high rigidity will be maintained, and heat resistance and linear thermal expansion coefficient will be good. If equal to or lower than the upper limit of any of the above ranges, flexibility will be good.

The content of the hydrogenated conjugated diene polymer block unit(s) (block(s) B) in the cyclic polyolefin (a) is preferably 1-70 mole %, and more preferably 10-60 mole %. Of these ranges, 50 mole % or less is further preferable, and 40 mole % or less is still further preferable.

By adjusting the content of the hydrogenated conjugated diene polymer block unit(s) (block(s) B) to a value equal to or higher than the lower limit of any of the above ranges, flexibility will be good. If equal to or lower than the upper limit of any of the above ranges, high rigidity will be maintained, and heat resistance and linear thermal expansion coefficient will be good.

The hydrogenated aromatic vinyl polymer block unit(s) and the hydrogenated conjugated diene polymer block unit(s) that constitute the cyclic polyolefin (a) are obtainable by hydrogenating polymer blocks composed of, respectively, the below-described aromatic vinyl monomers and conjugated diene monomers such as 1,3-butadiene.

Also, the cyclic polyolefin (a) is preferably a functional group-free block copolymer. The term "functional group-free" means that the block copolymer includes none of the functional groups, that is, includes none of the groups containing atoms other than carbon atoms and hydrogen atoms.

Description is now made of monomers for forming, respectively, the not-yet-hydrogenated aromatic vinyl polymer block unit and the not-yet-hydrogenated conjugated diene polymer block unit.

(Aromatic vinyl monomer)

The aromatic vinyl monomer as a raw material of the not-yet-hydrogenated aromatic vinyl polymer block unit is a monomer expressed by general Formula (1).

[Formula 1]

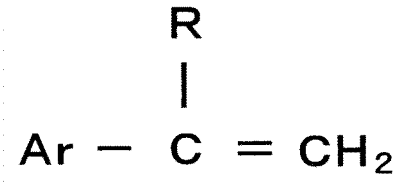

(1)

In Formula (1), R is hydrogen or an alkyl group; and Ar is one of a phenyl group, a halophenyl group, an alkyl phenyl group, an alkyl halophenyl group, a naphthyl group, a pyridinyl group, and an anthracenyl group.

If R is an alkyl group, the carbon number is preferably 1-6, and the alkyl group may be mono-substituted or multi-substituted by a functional group such as a halo group, a nitro group, an amino group, a hydroxy group, a cyano group, a carbonyl group, or a carboxyl group.

Ar of Formula (1) is preferably a phenyl group or an alkyl phenyl group, and particularly preferably a phenyl group,

Examples of aromatic vinyl monomers include styrene, $\alpha$-methyl styrene, vinyl toluene (including all of its isomers; particularly preferably p-vinyl toluene), ethyl styrene, propyl styrene, butyl styrene, vinyl biphenyl, vinyl naphthalene, vinyl anthracene (including all of its isomers), and their mixtures. Among them, styrene is preferable.

(Conjugated diene monomer)

The conjugated diene monomer as a raw material of the not-yet-hydrogenated conjugated diene polymer block unit is not particularly limited, provided it is a monomer having two conjugated double bonds.

Examples of such conjugated diene monomers include 1,3-butadiene, 2-methyl-1,3-butadiene (isoprene), 2-methyl-1,3-pentadiene, compounds similar thereto, and their mixtures. Among them, 1,3-butadiene is preferable.

If 1,3-butadiene is used as the conjugated diene monomer, since its polymer, namely polybutadiene, has a 1,4-bonding unit ([$-CH_2-CH=CH-CH_2-$]), and a 1,2-bonding unit ([$-CH_2-CH(CH=CH_2)-$]), by hydrogenation, the former gives the same structure as the repeating unit of polyethylene (ethylene structure), and the latter gives the same structure as the repeating unit when 1-butene is polymerized (1-butene structure). Thus, the hydrogenated conjugated diene polymer block according to the present invention preferably includes at least one of the ethylene structure and the 1-butene structure.

If isoprene is used as the conjugated diene monomer, its polymer, namely polyisoprene, has 1,4-bonding units ([$-CH_2-C(CH_3)=CH-CH_2-$]), 3,4-bonding-units ([$-CH_2CH(C(CH_3)=CH_2)-$]), and 1,2 bonding units ([$-CH_2-C(CH_3)(CH=CH_2)-$]). Thus, the hydrogenated polyisoprene includes at least one of the above three kinds of repeating units obtained by hydrogenation.

(Block structure)

The cyclic polyolefin (a) is preferably made by hydrogenating a multiblock copolymer such as a triblock copolymer, a tetrablock copolymer, or a pentablock copolymer, for example, type SBS, SBSB, SBSBS, SBSBSB, SIS, SISIS or SISBS (where S is polystyrene, B is polybutadiene, and I is polyisoprene). The blocks may be linear blocks, or may be branched. If branched, polymerization chains may be connected to any positions along the framework of the copolymer,

The blocks may be, besides linear blocks, tapered blocks, or star blocks.

The not-yet-hydrogenated block copolymer which constitutes the cyclic polyolefin (a) may include one or a plurality of additional block units other than the aromatic vinyl polymer block unit, and the conjugated diene polymer block unit. In the case of, for example, a triblock polymer, such additional block units may be connected to any positions of the framework of the triblock copolymer

The hydrogenated aromatic vinyl polymer block unit is preferably hydrogenated polystyrene. The hydrogenated conjugated diene polymer block unit is preferably hydrogenated polybutadiene or hydrogenated polyisoprene, and particularly preferably hydrogenated polybutadiene.

The cyclic polyolefin (a) is preferably a hydrogenated triblock or pentablock copolymer of styrene and butadiene, and preferably does not contain any other functional groups or structural modifiers.

(Hydrogenation level)

In the cyclic polyolefin (a), besides double bonds derived from conjugated diene such as butadiene, aromatic rings derived from e.g., styrene are also hydrogenated, and thus the cyclic polyolefin (a) is substantially completely hydrogenated. Specifically, the cyclic polyolefin has the following hydrogenation level.

The hydrogenation level of the hydrogenated aromatic vinyl polymer block unit is preferably 90% or more, more preferably 95% or more, further preferably 98% or more, and particularly preferably 99.5% or more.

The hydrogenation level of the hydrogenated conjugated diene polymer block unit is preferably 95% or more, more preferably 99% or more, and further preferably 99.5% or more.

By hydrogenation at such a high level, dielectric loss decreases, and rigidity and heat resistance improve.

The hydrogenation level of the hydrogenated aromatic vinyl polymer block unit is the rate at which the aromatic vinyl polymer block unit is saturated by hydrogenation, while the hydrogenation level of the hydrogenated conjugated diene polymer block unit is the rate at which the conjugated diene polymer block unit is saturated by hydrogenation.

The hydrogenation level of each block unit is determined by proton nuclear magnetic resonance (NMR).

Instead of a single cyclic polyolefin (a), a plurality of polyolefins may be used.

As the cyclic polyolefin (a) of the present invention, a commercially available one may be used. Specifically, "Tefabloc" (registered trademark) made by Mitsubishi Chemical Corporation can be used.

<Modified cyclic polyolefin (a’)>

As the cyclic polyolefin resin copolymer of the present invention, a modified cyclic polyolefin (a’) may be used. The modified cyclic polyolefin (a’) is obtained by modifying the cyclic polyolefin (a) with an unsaturated carboxylic acid and/or its anhydride.

By modifying the cyclic polyolefin (a), the polarity of the polymer increases, and thus improved adhesion with a metal layer such as a copper foil is expected.

<Modification process of the cyclic polyolefin (a)>

Modification process of the cyclic polyolefin (a) is now described. Modification is preferably carried out by adding, as a modification agent, an unsaturated carboxylic acid and/or its anhydride, to the cyclic polyolefin (a), for reaction with the cyclic polyolefin.

[Modification agent]

Unsaturated carboxylic acids and/or their anhydrides which can be used as the modification agent include, for example, unsaturated carboxylic acids such as acrylic acid, methacrylic acid, $\alpha$-ethylacrylic acid, maleic acid, fumaric acid, tetrahydrophthalic acid, methyltetrahydrophthalic acid, itaconic acid, citraconic acid, crotonic acid, isocrotonic acid, and nadic acids, and their anhydrides.

Specific anhydrides include maleic anhydride, citraconic anhydride, and nadic anhydride.

Specific nadic acids and their anhydrides include endocis-bicyclo[2.2.1]hept-2,3-dicarboxylate (nadic acid), and methyl-endocis-bicyclo[2.2.1]hept-5-ene-2,3-dicarboxylate (methyl nadic acid), and their anhydrides.

Of these unsaturated carboxylic acids and/or their anhydrides, acrylic acid, maleic acid, nadic acid, maleic acid anhydride, and nadic acid anhydrate are preferable.

One of these unsaturated carboxylic acids and/or their anhydrides may be used alone, or two or more of them may be used in combination.

[Method of modification]

The modified cyclic polyolefin (a') is obtainable by modifying the cyclic polyolefin (a) with one or more of the above-described unsaturated carboxylic acids and/or their anhydrides. Other suitable modification methods include solution modification, melt modification, solid state modification by irradiation of electron beams or ionizing radiation, and modification in a supercritical fluid.

Among them, melt modification, which needs no expensive facility, and is cost-competitive, is preferable, and melt-kneading modification using an extruder is particularly preferable, because it allows continuous production.

Devices usable for this purpose include a single-screw extruder, a twin-screw extruder, a banbury mixer, and a roll mixer. Among them, a single-screw extruder and a twin-screw extruder, which allow continuous production, are preferable.

Modification of the cyclic polyolefin (a) with an unsaturated carboxylic acid and/or its anhydride is ordinarily carried out by graft reaction, in which carbon radicals are produced by cleaving the carbon-hydrogen bonds of the hydrogenated conjugated diene polymer block unit which is one of the block units forming the cyclic polyolefin (a), and unsaturated groups are attached thereto.

The carbon radicals may be produced, besides using electron beams or by ionizing radiation as described above, by raising temperature, or using a radical producing agent such as an organic peroxide, an inorganic peroxide, or an azo compound. As the radial producing agent, an organic peroxide is preferable from the viewpoint of the cost and ease of handling.

Examples of azo compounds usable in the invention include azobis(isobutyronitrile), azobis(dimethylvaleronitrile), azobis(2-methylbutyronitrile), and diazonitrophenol.

Examples of inorganic peroxides usable in the invention include hydrogen peroxide, potassium peroxide, sodium peroxide, calcium peroxide, magnesium peroxide, and barium peroxide.

Examples of organic peroxides usable in the invention include hydroperoxides, dialkylperoxides, diacylperoxides, peroxyesters, and ketone peroxides.

Specific examples of such organic peroxides include hydroperoxides such as cumene hydroperoxide, and t-butyl hydroperoxide; dialkylperoxides such as dicumyl peroxide, di-t-butylperoxide, 2,5-dimethyl-2,5-di(t-butylperoxy)hexane, and 2,5-dimethyl-2,5-di(t-butylperoxy)hexyne-3; diacylperoxides such as lauryl peroxide, and benzoyl peroxide; peroxyesters, such as t-butyl peroxy acetate, t-butyl peroxy benzoate, and t-butyl peroxy isopropyl carbonate; and ketone peroxides such as cyclohexanone peroxide.

One of these radical producing agents may be used alone, or two or more of them may be used in combination.

[Melt-kneading modification]

In a generally used melt-kneading process, a mixture of the cyclic polyolefin (a), an unsaturated carboxylic acid and/or its anhydride, and an organic peroxide is placed into a kneader and an extruder, extruded while being heated, melted and kneaded, and the molten resin that comes out of the tip-die is cooled, for example, in a tank, to obtain the modified cyclic polyolefin (a').

The content of the unsaturated carboxylic acid(s) and/or its(their) anhydride(s) is 0.2-5 parts by mass based on 100 parts by mass of the cyclic polyolefin (a). By setting this parameter equal to or higher than the lower limit of the above range, a predetermined modification rate necessary to achieve the results expected in the present invention, is achievable. If equal to or lower than the upper limit, no unreacted unsaturated carboxylic acid(s) and/or its(their) anhydrate(s) will remain, and the dielectric properties will be good, too.

The content of the organic peroxide(s) is 20-100 parts by mass based on 100 parts by mass of the unsaturated carboxylic acid(s) and/or its(their) anhydride(s).

By setting this parameter equal to or higher than the lower limit of the above range, a predetermined modification rate necessary to achieve the results expected in the present invention, is achievable. If equal to or lower than the upper limit, the cyclic polyolefin (a) will not deteriorate, and will maintain a good color phase.

For the melt/knead modification conditions, the ingredients are preferably extruded, if a single-screw or twin-screw extruder is used, at a temperature of 150-300°C.

[Modification rate]

The modification rate of the modified cyclic polyolefin (a') modified with the unsaturated carboxylic acid(s) and/or its(their) anhydride(s) is preferably 0.1-2% by mass.

Setting the modification rate to a value equal to or higher than the lower limit of the above range is preferable because the polarity increases, and thus adhesion with a metal layer such as a copper foil improves. If equal to or lower than the upper limit of the above range, the cyclic polyolefin (a) maintains low dielectric loss, and is free of odors and

color deterioration.

The modification rate of the modified cyclic polyolefin (a') can be measured by proton NMR after subjecting the modified cyclic polyolefin (a') to methyl esterification.

(Other components)

The resin layer (A) of the present invention may optionally contain, for further improvement in functionality, components other than the cyclic polyolefin resin copolymer. Such optional components include ultraviolet preventing agents, antistatic agents, antioxidants, coupling agents, plasticizers, flame retardants, colorants, dispersants, emulsifiers, elasticity reducing agents, diluents, defoaming agents, ion trapping agents, inorganic fillers, and organic fillers.

«Properties of the resin sheet»

The dielectric loss tangent of the resin sheet according to the present invention is, at 12 GHz, preferably less than 0.005, more preferably less than 0.002, and further preferably less than 0.001. Since the lower the dielectric loss tangent, the lower the dielectric loss, this value is preferably as low as possible for improved transmission efficiency and speed of electric signals when the resin sheet is used as a circuit board material. The lower limit of the dielectric loss tangent is not particularly limited unless it is less than zero.

The haze of the resin sheet according to the present invention is preferably 10% or less, more preferably 5% or less, and further preferably 3% or less. By setting the haze to a value equal to or lower than the upper limit of the above range, the resin sheet has enough transparency. The lower limit of the haze is not particularly limited unless it is less than zero.

The thickness of the resin sheet is preferably 10 $\mu$m or more and 200 $\mu$m or less. By using the resin sheet of which the thickness is adjusted within this range for a material of a circuit board, it is possible to reduce the size of an electric or electronic device carrying this circuit board, while maintaining suitable strength.

<Method of making the resin sheet>

It is to be noted that the below-described method of making the resin sheet of the present invention is one example of possible methods of making the resin sheet of the present invention, and the resin sheet according to the present invention is not limited to the resin sheet made by the below-described method.

The resin sheet of the present invention can be made, for example, by melt-blending the cyclic polyolefin resin copolymer, and other optional components with e.g., a single-screw or twin-screw extruder, coextruding them with a T-die, and rapidly cooling and solidifying them on a cast roll.

When making the resin sheet by kneading with e.g., an extruder, the material is melt-kneaded at an elevated temperature of ordinarily 180-300°C, and more preferably 220-280°C,

«Use of the resin sheet»

Examples of the use of the resin sheet according to the present invention include, but not limited to, copper-clad laminates, flexible printed circuit boards, multi-layered printed wiring boards, materials for circuit boards for electric and electronic devices such as capacitors, underfill materials, interchip fills for 3D-LSI's, insulating sheets, and heat dissipating boards.

«First embodiment»

If higher flex resistance is desired for the resin sheet of the present invention, the resin layer (A) preferably contains at least one thermoplastic resin (b) selected from the group consisting of an ethylene-based polymer, an olefin-based thermoplastic elastomer, and a styrene-based thermoplastic elastomer.

In particular, the first embodiment is a resin sheet (i) which contains a cyclic polyolefin resin copolymer having a crystal melting peak temperature of less than 100°C, and at least one thermoplastic resin (b) selected from the group consisting of an ethylene-based polymer, an olefin-based thermoplastic elastomer, and a styrene-based thermoplastic elastomer; and (ii) of which the dielectric loss tangent at 12 GHz is less than 0.005.

Because the compatibility of these thermoplastic resins (b) with the cyclic polyolefin resin copolymer is good, the transparency of the resin sheet obtained is also good.

Good flex resistance of the resin sheet means that the resin sheet is less likely to break when deflected, and thus suitable for use for e.g., flexible printed circuit boards (FPC). Also, breakage and cracks of the sheet are prevented when the sheet is formed by taking it up in a roll, stored and transported.

Examples of ethylene-based polymers include homopolymers of ethylene, and copolymers of ethylene and another monomer.

The copolymer of ethylene and the other monomer of the invention preferably contains ethylene as a major component. Here, the language "contains ethylene as a major component" means that the copolymer contains 50 mole % or more, preferably 60 mole % or more, ethylene structural units.

The other monomer that is copolymerized with ethylene is not particularly limited, provided it is copolymerizable with ethylene.

Preferable examples of the ethylene-based polymer include a low-density polyethylene (LDPE), a linear low-density polyethylene (LLDPE), and a polyethylene obtained by polymerization using a metallocene-based catalyst. Among them, due to its high flexibility, a linear low-density polyethylene (LLDPE) is preferable.

The olefin-based thermoplastic elastomer contains polyolefin as hard segments and a rubber component as soft segments.

The olefin-based thermoplastic elastomer may be (i) a mixture (polymer blend) of the above-mentioned polyolefin and the above-mentioned rubber component; (ii) obtained by cross-linking the polyolefin with the rubber component; or (iii) a polymer obtained by polymerizing the polyolefin and the rubber component.

The polyolefin may be, for example, polypropylene or polyethylene.

Examples of the rubber component include diene-based rubbers such as isoprene rubber, butadiene rubber, butyl rubber, propylene-butadiene rubber, acrylonitrile-butadiene rubber, and acrylonitrile-isoprene rubber; ethylene-propylene non-conjugated diene rubbers; and ethylene-butadiene copolymer rubbers.

Examples of the above styrene-based thermoplastic elastomer include styrene-butadiene-styrene block copolymers, styrene-isoprene-styrene block copolymers, hydrogenated styrene-butadiene-styrene block copolymers and hydrogenated styrene-isoprene-styrene block copolymers.

Among the above-described thermoplastic resins (b), from the viewpoint of flex resistance, a styrene-based thermoplastic elastomer is preferable, and a hydrogenated styrene-butadiene-styrene block copolymer is particularly preferable.

The storage elastic modulus of the thermoplastic resin (b) at 24°C is preferably 0.1 MPa or more, and more preferably 1 MPa or more. Further, this parameter is preferably less than 500 MPa, more preferably less than 300 MPa, and further preferably less than 50MPa. By setting the storage elastic modulus lower than any of the above upper limits, suitable flexibility is imparted to the cyclic polyolefin resin copolymer when blended with it, thereby improving flex resistance. By setting the storage elastic modulus equal to or higher than any of the lower limits, blocking of the thermoplastic resin (b) and sticking of the sheet are prevented, which results in improved productivity.

The density of the thermoplastic resin (b) is preferably 930 g/cm$^3$ or less, more preferably 920 g/cm$^3$ or less, and further preferably 910 g/cm$^3$ or less.

By setting the density to the above value or less, the storage elastic modulus of the thermoplastic resin (b) tends to decrease, so that suitable flexibility is imparted when blended with the cyclic polyolefin resin copolymer, and flex resistance improves.

The dielectric loss tangent of the thermoplastic resin (b) is, at 12 GHz, preferably less than 0.005 and more preferably less than 0.001. Since the smaller the dielectric loss tangent, the lower the dielectric loss, this value is preferably as small as possible for improved transmission efficiency and speed of electric signals when the resin sheet is used as a circuit board material. The lower limit of the dielectric loss tangent is not particularly limited unless it is less than zero.

The content of the thermoplastic resin (b) in the resin layer (A) is preferably 5% by mass or more, and more preferably 10% by mass or more, of the resin components constituting the resin layer (A). Also, this content is preferably 50% by mass or less, and more preferably 30% by mass or less. By setting the content of the thermoplastic resin (b) to a value equal to or higher than the above lower limit, the cyclic polyolefin resin copolymer has enough flexibility and improved flex resistance. On the other hand, by setting the content of the thermoplastic resin (b) to a value equal to or lower than the above upper limit, the cyclic polyolefin resin copolymer maintains its inherent properties, such as low dielectric properties and heat resistance.

Of the above-listed thermoplastic resins (b), only one may be used alone, or two or more may be used in combination.

If the resin layer (A) contains at least one thermoplastic resin (b), the storage elastic modulus of the resin layer (A) at 24°C is preferably 50 MPa or more, more preferably 100 MPa or more, and further preferably 200 MPa or more. Further, the value of this parameter is preferably less than 2000 MPa, more preferably less than 1800 MPa, and further preferably less than 1700 MPa. By setting the storage elastic modulus equal to or higher than any of the above lower limits, the sheet is sufficiently stiff, and slackness and wrinkles of the sheet are prevented when forming or processing the sheet. By setting the storage elastic modulus to less than any of the above upper limits, the sheet has sufficient flexibility, and thus improved flex resistance. Cracks of the sheet are thus prevented when the sheet is wound on a roll to form the sheet or when the sheet is blanked to form a substrate.

<<Second embodiment>>

If it is desired to reduce the linear thermal expansion coefficient of the resin sheet according to the present invention, the resin sheet preferably contains a glass cloth (C).

The resin layer (A) and the glass cloth (C) may be integral with each other, or separate from each other.

For example, the resin layer (A) may be a composite of which the glass cloth (C) is impregnated with the cyclic polyolefin resin copolymer such that the cyclic polymer resin copolymer and the glass cloth are integrated with each other.

In an alternative arrangement, the resin layer (A), comprising the above-described cyclic polyolefin resin copolymer, and the glass cloth (C), are prepared as separate members, and the resin layer (A) is laminated on one or either of the opposite surfaces of the glass cloth (C).

Of these arrangements, from the viewpoint of low dielectric properties and low linear thermal expansion coefficient, the first arrangement is preferable, in which the resin sheet (A) is a composite of which the glass cloth (C) is impregnated with the cyclic polyolefin resin copolymer such that the cyclic polyolefin resin copolymer and the glass cloth (C) are integrated with each other.

To summarize, the first arrangement of the second embodiment of the present invention is a resin composite containing a cyclic polyolefin resin copolymer having a crystal melting peak temperature of less than 100°C, and a glass cloth (C),

The second arrangement of the present invention is a resin laminate including a resin layer or layers (A) containing a cyclic polyolefin resin copolymer having a crystal melting peak temperature of less than 100°C, and a glass cloth (C).

By reducing the linear thermal expansion coefficient of the resin sheet, when forming a circuit board material by laminating the resin sheet and a conductor such as a metal layer, the difference in linear thermal expansion coefficient between the resin sheet and the conductor is small, and thus curling and warping after lamination are minimum.

In a generally known way to reduce the linear thermal expansion coefficient of the resin sheet, an inorganic filler having a low thermal expansion coefficient is added to the sheet material. However, to achieve the expected results, such an inorganic filler has to be added in large amounts. Moreover, if a thermoplastic resin is used as the sheet material, the addition of a large amount of such filler would make melt-kneading and extrusion difficult. In another known method of reducing the linear thermal expansion coefficient, glass fiber is impregnated with the above inorganic filler. However, this method has the problem of anisotropy.

In this embodiment, by using a glass cloth (C), it is possible to isotropically reduce the linear thermal expansion coefficient. Another advantage of a glass cloth (C) is that its content is easily adjustable.

The content of the glass cloth (C) is, based on 100% by volume of the resin layer (A), preferably 1% by volume or more, more preferably 3% by volume or more, and further preferably 4% by volume or more. Also, 60% by volume or less is preferable, 40% by volume or less is more preferable, and 20% by volume or less is further preferable. By setting the content of the glass cloth (C) to a value equal to or higher than any of the above lower limits, the linear thermal expansion coefficient of the resin sheet should decrease, and if equal to or lower than any of the above upper limits, the resin sheet will still be sufficiently lightweight, and still maintain sufficient flexibility.

The dielectric loss tangent of the glass cloth (C) is, at 10 GHz, preferably less than 0.005, and more preferably less than 0.0005. Since the smaller the dielectric loss tangent, the lower the dielectric loss, this value is preferably as small as possible for improved transmission efficiency and speed of electric signals when the resin sheet is used as a circuit board material. The lower limit of the dielectric loss tangent is not particularly limited unless it is less than zero.

The average linear thermal expansion coefficient of the glass cloth (C) is, within the temperature range of 0°C-100°C, preferably less than 5 ppm/°C, and more preferably less than 3 ppm/°C. By setting the linear thermal expansion coefficient lower than either of the above upper limits, the linear thermal expansion coefficient of the resin sheet decreases.

The thickness of the glass cloth (C) is preferably 10 μm or more and 200 μm or less. Because, by setting the thickness within this range, the glass cloth (C) is flexible enough to be easily deflectable, the resin sheet maintains a sufficiently low linear thermal expansion coefficient, while, at the same time, maintaining sufficient flexibility, thus making the resin sheet suitable as a material of a circuit board that contributes to a reduction in size of an electric or electronic device carrying the circuit board.

In order to prevent separation from the resin by improving its affinity for the resin, the glass sheet (C) may have its surface treated beforehand with a silane-based compound, such as vinyl triethoxy silane, 2-aminopropyl triethoxy silane, or 2-glycydoxy propyl trimethoxy silane.

Specific examples of the glass sheet (C) include "NE glass" made by Nitto Boseki Co., Ltd., and quartz glass made by Shin-Etsu Chemical Co., Ltd., called "SQX series".

The average linear thermal expansion coefficient of the resin sheet of this embodiment is, within the temperature range of 0°C-100°C, preferably less than 80 ppm/°C, and more preferably less than 65 ppm/°C. By setting the thermal expansion coefficient of the resin sheet to less than either of the above upper limits, the difference in thermal expansion coefficient between the resin sheet and a metal layer such as a copper foil is small, so that curling and warping are

minimum when the metal layer is laminated on the resin sheet.

As necessary, the resin sheet of this embodiment may contain other components other than the above-described other components of the resin layer (A). Examples of such other components other than the above-described other components of the resin layer include, heat stabilizers, weathering stabilizers, slip agents, anti-blocking agents, anti-fogging agents, lubricants, dyes, pigments, natural oils, synthetic oils, waxes, organic fillers, inorganic fillers, thermoplastic resins other than cyclic polyolefin resin copolymers, and thermosetting resins. Their contents are not limited unless they ruin the object of the present invention.

Specific examples of optionally added stabilizers include:

(i) phenol-based antioxidants such as tetrakis[methylene-3(3,5-di-t-butyl-4-hydroxyphenyl)propionate]methane, β-(3,5-di-t-butyl-4-hydroxyphenyl)alkyl propionate ester, and 2,2'-oxyamidebis[ethyl-3(3,5-di-t-butyl-4-hydroxyphenyl)]propionate;
(ii) fatty acid metal salts such as zinc stearate, calcium stearate, and calcium 12-hydroxystearate; and
(iii) polyhydric alcohol fatty acid esters such as glycerin monostearate, glycerin monolaurate, glycerin distearate, and pentaerythritol tristearate.

One of them may be used alone or a plurality of them may be used in combination. Such combinations include, for example, the combination of tetrakis[methylene-3(3,5-di-t-butyl-4-hydroxyphenyl)propionate]methane with zinc stearate and glycerin monostearate.

<Method of making the resin sheet of the second embodiment>

The resin sheet of the second embodiment is preferably made by one of the following first and second methods.

[First method of making the resin sheet]

The first method includes the following steps (1) and (2):

(1) Sheet forming step, in which a sheet-shaped object is obtained from the cyclic polyolefin resin copolymer; and
(2) Lamination step, in which the sheet-shaped object and the glass cloth are laminated one on top of the other.

(1. Sheet forming step)

In the sheet forming step, the cyclic polyolefin resin copolymer is formed into a sheet shape.

The method of making the sheet is not particularly limited, and a known method can be used. For example, the molten cyclic polyolefin resin can be extruded from a T-die, and formed by casting with casting rolls (such as chill rolls, or casting drums).

If additives other than the cyclic polyolefin resin copolymer are used, the sheet may be formed after kneading together, in a kneader, the cyclic polyolefin resin copolymer and the additives. The kneading method and the type of the kneader used are not particularly limited, and the kneader may be a known extruder, such as, for example, a single-screw extruder, a twin-screw-extruder, or a multi-screw extruder.

(2. Lamination step)

In the lamination step, the sheet-shaped object and the glass cloth (C) that are obtained in the sheet forming step are laminated one on top of the other.

The method of lamination is not particularly limited, and may be a known one. For example, the sheet-shaped object and the glass cloth (C) may be bonded together by an adhesive.

In another possible arrangement, after laminating together the sheet-shaped object and the glass cloth (C), a press-impregnation step is carried out in which the cyclic polyolefin resin copolymer is impregnated into the glass cloth (C) by hot pressing. By this press-impregnation step, the cyclic polyolefin resin copolymer and the glass cloth (C) are integrated to form a composite.

The method and temperature of the hot pressing are not particularly limited. For example, the resin composite may be obtained by superposing the glass cloth (C) on one or either side of the sheet-shaped object; sandwiching them between two flat plates; hot-pressing them at a temperature equal to or higher than the resin flow start temperature, for 0.5-10 minutes, and at a pressure of 0.1-1 MPa; cooling them to room temperature; and releasing the pressure.

[Second method of making the resin sheet]

The second method includes a direct application step in which the cyclic polyolefin resin copolymer is directly

applied to the glass cloth (C). By this direct application, the cyclic polyolefin resin copolymer is impregnated into the glass cloth (C) such that the cyclic polyolefin resin copolymer and the glass cloth (C) are integrated, forming a composite.

The method of applying the cyclic polyolefin resin copolymer is not particularly limited, and exemplary methods include comma coating, reverse coating, knife coating, dip coating, dip-nipping, kiss coating, air knife coating, spin coating, roll coating, printing, dipping, slide coating, curtain coating, die coating, casting, and extrusion coating.

«Third embodiment»

If it is desired to reduce the linear thermal expansion coefficient of the resin sheet according to the present invention, the resin sheet is preferably a laminate including the above-described resin layer (A), and a resin layer (D) containing an amorphous resin (d) having a glass transition point of 100°C or more and a dielectric loss tangent, at 12 GHz, of less than 0.02.

In other words, the third embodiment of the present invention is a resin laminate including a resin layer (A) containing a cyclic polyolefin resin copolymer having a crystal melting peak temperature of less than 100°C, and a resin layer (D) containing an amorphous resin (d) having a glass transition point of 100°C or more and a dielectric loss tangent, at 12 GHz, of less than 0.02.

The resin sheet of this embodiment is hereinafter sometimes referred to as the "resin laminate".

<Resin layer (A)>

The resin layer (A) of this embodiment is the same as the resin layer (A) described under the subtitle of <<Resin layer (A)>> above.

<Resin layer (D)>

The resin layer (D) of this embodiment contains an amorphous resin (d) having a glass transition point of 100°C or more and a dielectric loss tangent, at 12 GHz, of less than 0.02. By using an amorphous resin, the resin layer (D) can be laminated, in a desirable manner and without separation, on the resin layer (A), which contains a cyclic polyolefin resin copolymer, of which the amorphous content is high.

<<Amorphous resin (d)>>

The amorphous resin (d) has a glass transition point of 100°C or more, preferably 120°C or more, and more preferably130°C or more. Also, this parameter is preferably less than 200°C, more preferably less than170°C, and further preferably less than 150°C. By setting the glass transition point of the amorphous resin (d) to a value equal to or higher than any of the above lower limits, heat resistance improves, and as a result, dimensional changes due to linear thermal expansion when heated, and due to shrinkage during cooling, will be minimum. On the other hand, by setting the glass transition point to less than any of the above upper limits, the amorphous resin (d) can be laminated in a favorable manner without separation and without uneven lamination, on the resin layer (A) containing the cyclic polyolefin resin copolymer.

The glass transition point is measured using a differential scanning calorimeter (DSC) under JIS K7121 (2012) at a heating rate of 10°C/minute.

The dielectric loss tangent, at 12 GHz, of the amorphous resin (d) of the resin layer (D) is preferably less than 0.02, and more preferably less than 0.01. Since the smaller the dielectric loss tangent, the lower the dielectric loss, this value is preferably as small as possible for improved transmission efficiency and speed of electric signals when the resin sheet is used as a circuit board material. The lower limit of the dielectric loss tangent is not particularly limited unless it is less than zero.

The amorphous resin (d) of the resin layer (D) preferably comprises at least one of the resins selected from the group consisting of an alicyclic olefin polymer, a polycarbonate, a polyarylate, a polysulfone, and a copolymer thereof. Among them, from the viewpoint of low dielectric properties, an alicyclic olefin polymer is more preferable.

Alicyclic olefin polymers are polymers having structural units derived from alicyclic olefins, and specifically refer to ring-opened, optionally hydrogenated polymers of alicyclic olefins, addition (co)polymers of alicyclic olefins, random copolymers of alicyclic olefins and $\alpha$-olefins such as ethylene or propylene, and graft (co)polymers obtained by modifying the above (co)polymers with, for example, unsaturated carboxylic acids or their derivatives. Among them, the following are preferable in the present invention: (i) a cyclic olefin copolymer (COC) obtained by addition-polymerizing norbornene and ethylene units; and (ii) a cyclic olefin polymer (COP) obtained by subjecting norbornene or dicyclopentadiene to ring-opening polymerization, and stabilizing it by hydrogenation.

Polycarbonates are linear polymer molecules having a carbonate ester bond at the main chain. They are

polymers obtainable by, for example, reacting various dihydroxydiaryls by ester exchange. Specific polycarbonates include 2,2-bis(4-hydroxyphenyl)propane (bisphenol A), and a polycarbonate made from phosgene or diphenyl carbonate. However, the polycarbonate of this embodiment is not limited to those mentioned above.

The above-mentioned polyarylate is obtained by polycondensation of dicarboxylic acid components and bivalent phenol components. The glass transition point of the polyarylate is adjustable by selecting a suitable dicarboxylic acid component and bivalent phenol component. Specifically, the polyarylate of the invention may be, but is not limited to, a polyarylate composed of terephthalic acid, isophthalic acid, and bisphenol A.

Polysulfones are high molecules having a sulfonyl group. They are made by, for example, copolymerization of olefin and sulfoxide, but the polysulfone of the present invention may be made by a different method.

The content of the amorphous resin (d) in the resin layer (D) of this embodiment is preferably 30% by mass or more, more preferably 50% by mass or more, and further preferably 70% or more. The resin layer (D) may be composed solely of the amorphous resin (d) (100% by mass). By setting the content of the amorphous resin (d) equal to or higher than any of the above lower limits, when the resin layer (D) is laminated on the resin layer (A), the heat resistance improves and the linear thermal expansion coefficient decreases.

As mentioned above, the resin layer (D) contains at least one amorphous resin (d) selected from the above-listed resins, which means that, instead of one, but two or more of the above-listed resins may be selected as amorphous resins(d).

The resin layer (D) of this embodiment may contain, for the purpose of improving various functions, components other than the amorphous resin(s). Specifically, in order to improve adhesion to the resin layer (A), the same cyclic polyolefin resin copolymer as used in the resin layer (A) may be added; or in order to improve the flex resistance of the resin laminate according to the present invention, a thermoplastic elastomer may be added. Further components that can be optionally added to the resin layer (D) include ultraviolet preventing agents, antioxidants, coupling agents, plasticizers, flame retardants, colorants, dispersants, emulsifiers, elasticity reducing agents, diluents, defoaming agents, ion trapping agents, inorganic fillers, and organic fillers.

<Structure of the resin laminate>

The resin laminate of this embodiment includes at least one resin layer (A) and at least one resin layer (D).

In particular, the resin laminate may be a two-layer structure composed of a single resin layer (A) and a single resin layer (D); a three-layer structure composed of a single resin layer (D) and two resin layers (A) each disposed on either side surface of the resin layer (D); another three-layer structure composed of a single resin layer (A) and two resin layers (D) each disposed on either side surface of the resin layer (A); and a multi-layer structure composed of a plurality of resin layers (A) and a plurality of resin layers (D) that are laminated together, alternating with each other. Further, a resin layer or layers other than the resin layers (A) and (B) may be disposed on one side surface of the resin layer(s) (A) and/or the resin layer(s) (B). Specifically, the resin laminate may include, for example, adhesive layers for improving the adhesion between the resin layers, and/or coloring resin layers for improving visibility of the resin laminate.

Among them, in order to reduce warping of the resin laminate, the following structures are preferable: a structure in which two resin layers (A) each form a respective outermost layer of the resin laminate, and a structure in which two resin layers (D) each form a respective outermost layer of the resin laminate. Such preferred structures include a three-layer structure composed of a single resin layer (D) and two resin layers (A) each disposed on either side surface of the resin layer (D); a three-layer structure composed of a single resin layer (A) and two resin layers (D) each disposed on either side surface of the resin layer (A); a multi-layer structure composed of a plurality of resin layers (A) and a plurality of resin layers (D) that are laminated together, alternating with each other, such that two of the resin layers (A) each form a respective outermost layer of the resin laminate; and a multi-layer structure composed of a plurality of resin layers (A) and a plurality of resin layers (D) that are laminated together, alternating with each other, such that two of the resin layers (D) each form a respective outermost layer of the resin laminate.

In an arrangement in which the resin layers (A) contain the modified cyclic polyolefin (a'), from the viewpoint of adhesion to a metal foil, at least one of the outermost layers of the resin laminate is preferably formed by one of the resin layers (A). More preferably, both of the outermost layers are resin layers (A).

The thickness of the resin laminate of this embodiment is not particularly limited, but for workability and practicality, the range of about 10-200 $\mu$m or more is preferable.

The thickness of the resin layer (A) (if a single resin layer (A) is used), and the total thickness of the plurality of resin layers (A) (if a plurality of resin layers (A) are used) are both preferably 10-60% of the thickness of the entire resin laminate. The thickness of the resin layer (D) (if a single resin layer (D) is used), and the total thickness of the plurality of resin layers (D) (if a plurality of resin layers (D) are used) are both preferably 40-90% of the thickness of the entire resin laminate. By setting the respective thicknesses within the above ranges, the resin layer(s) (D) will sufficiently contribute to improved heat resistance and reduction in linear thermal expansion coefficient.

<Properties of the resin laminate>

The dielectric loss tangent at 12 GHz of the resin laminate according to this embodiment is preferably less than 0.005, and more preferably less than 0.002. Since the smaller the dielectric loss tangent, the lower the dielectric loss, this value is preferably as small as possible for improved transmission efficiency and speed of electric signals when the resin sheet is used as a circuit board material. The lower limit of the dielectric loss tangent is not particularly limited unless it is less than zero.

The average linear thermal expansion coefficient of the resin laminate according to this embodiment is, within the temperature range of 0°C-100°C, preferably 15 ppm/°C or more, and more preferably 20 ppm/°C or more. Also, the value of this parameter is preferably 115 ppm/°C or less, and more preferably 100 ppm/°C or less. By setting the linear thermal expansion coefficient of the resin laminate within any of the above ranges, it is possible to reduce shrinkage of products formed from this resin laminate, or to reduce curling and warping of the resin laminate after lamination due to a difference in shrinkage ratio between the resin laminate and a metal layer such as a copper foil when the laminate is used as the material of a circuit board for electric or electronic devices.

<Method of making the resin laminate>

A method of making the resin laminate of this embodiment is now described. It is to be understood that the following description is regarding only one of a number of possible methods of making the resin laminate according to the present invention, and the resin laminate according to the present invention is not limited to the particular resin laminate made by the method described below.

The resin laminate of this embodiment can be made by melt-blending a cyclic polyolefin resin copolymer as the raw material of the resin layer(s) (A) and other additives with a single-screw or twin-screw extruder; melt-blending, in the same manner as with the sheet(s) A, an amorphous resin(d) as the raw material of the resin layer(s) (D) and other additives; coextruding them through a T-die; and rapidly cooling them with casting rolls to solidify them.

As a method of laminating together the resin layer(s) (A) and the resin layer(s) (D), they may be laminated together by, as described above, coextrusion, or the resin layer(s) (A), the resin layer(s) (D), and other layers may be separately formed, and laminated together by laminating or hot pressing. When laminating, adhesive layers may be disposed between the resin layers to improve the adhesiveness between the layers.

<Use of the resin laminate>

The resin laminate of this embodiment can be used as materials for circuit boards, such as copper foil laminated boards, flexible printed boards, multi-layered printed wiring boards, laminated boards for electric and electronic circuits such as capacitors, underfill materials, interchip fills for 3D-LSI's, insulating sheets, and heat dissipating boards. However, the use of this resin laminate is not limited to what is listed above.

<<Circuit board material>>

The resin sheet of any of the first to third embodiments of the present invention can be used as a circuit board material by laminating together the resin sheet and a conductor.

The conductor may be a metal foil or a metal layer formed by plating or sputtering, both comprising a conductive metal such as copper or aluminum, or an alloy thereof.

If used as a material for circuit boards of electric or electronic devices, the thickness of the resin sheet is preferably 10 $\mu$m or more and 200 $\mu$m or less, while the thickness of the conductor is preferably 0.2 $\mu$m or more and 70 $\mu$m or less.

The circuit board material according to the present invention is characterized by its sufficiently low dielectric loss tangent.

The dielectric loss tangent at 12 GHz of the circuit board material is preferably less than 0.01, and more preferably less than 0.008. Since the smaller the dielectric loss tangent, the lower the dielectric loss, this value is preferably as small as possible for improved transmission efficiency and speed of electric signals when the resin sheet is used as a circuit board material. The lower limit of the dielectric loss tangent is not particularly limited unless it is less than zero.

<Method of making the circuit board material>

The circuit board material can be made, for example, as follows.

A necessary number of layers are prepared each by laminating a conductor on the resin sheet of each of the first to third embodiments, and then forming a circuit thereon using, for example, a photoresist, and the layers are

superposed one on top of another.

The resin sheet and the conductor may be laminated together by directly superposing a conductive metal foil on the resin sheet, or by bonding together the resin sheet and a conductive metal foil using an adhesive. Further alternatively, a conductive metal layer may be formed by plating or sputtering, or these methods may be used in combination.

EXAMPLES

The present invention is now described in a detailed manner, using the following Examples. It is, however, to be understood that the present invention is by no means limited to these Examples. The values of the various production conditions and the evaluation results of the Examples should be understood to be preferable values of the upper limits and the lower limits of the embodiments of the present invention, and the preferred ranges may be defined by the combinations of the values of the above-described upper limits or lower limits and the values of the below Examples, or the combinations of the values of the respective Examples.

In the following description, "part(s)" refers to "part(s) by mass".

<<Test Example 1: Physical properties and evaluation of the cyclic polyolefin resin copolymer»

In Test Example 1, for the below-specified materials a-1 and a-2, and material a-101, which are examples of the cyclic polyolefin resin copolymer according to the present invention, the physical properties were measured and evaluation was made. The results are shown in Table 1.

<Measurement of physical properties • Evaluation>

(1) Molecular weight (MW)

- Device: GPC HLC-832GPC/HT, made by TOSOH Corporation
- Detector: 1A infrared spectrophotometer (wavelength measured: 3.42 μm), made by MIRAN
- Columns; Three columns AD806M/S, made by Showa Denko K.K. (Columns were calibrated by measuring monodisperse polystyrene made by TOSOH (0.5mg/ml solution of each of A500, A2500, F1, F2, F4, F10, F20, F40 and F288), and approximating the logarithmic value of the elution volume and the molecular weight by the cubic formula.)
- Temperature at which measurement was made: 135°C
- Concentration: 20 mg/10mL
- Injected amount: 0.2 ml
- Solvent: o-dichlorobenzene
- Flow rate: 1.0 ml/minute

(2) Rate of polymer blocks

[Measurement by carbon NMR]

- Device: "AVANCE 400 spectrometer" made by Bruker
- Solvent: Mixed solvent of o-dichlorobenzene-$h_4$/ρ-dichlorobenzene-$d_4$
- Concentration: 0.3 g/2.5 mL
- Measurement: $^{13}$C-NMR
- Resonant frequency: 400 MHz
- Cumulative number: 3600
- Flip angle: 45 degrees
- Data acquisition time: 1.5 seconds
- Pulse repeating time: 15 seconds
- Temperature at which measurement was made: 100°C
- $^{1}$H irradiation: Complete decoupling

(3) Hydrogenation levels of the hydrogenated aromatic vinyl polymer block unit and the hydrogenated conjugated diene polymer block unit

[Measurement by proton NMR]

- Device: "AVANCE 400 spectrometer" made by Bruker
- Solvent: Tetrachloroethane
- Concentration: 0.045 g/1.0 mL
- Measurement: $^1$H-NMR
- Resonant frequency: 400 MHz
- Flip angle: 45 degrees
- Data acquisition time: 4 seconds
- Pulse repeating time: 10 seconds
- Cumulative number: 64
- Temperature at which measurement was made: 80°C
- Hydrogenation level of the hydrogenated aromatic viny polymer block unit: integrated reduction rate of 6.8-7.5 ppm
- Hydrogenation level of the hydrogenated conjugated diene polymer block unit: integrated reduction rate of 5.7-6.4 ppm

(4) Modification rate of the modified cyclic polyolefin

[Measurement by proton NMR]

- Device: "AVANCE 400 spectrometer" made by Bruker
- Solvent: ortho-dichlorobenzene-d4
- Concentration: 20 mg/0.62 mL
- Measurement: $^1$H-NMR
- Resonant frequency: 400 MHz
- Flip angle: 45 degrees
- Data acquisition time: 4 seconds
- Pulse repeating time: 10 seconds
- Cumulative number: 64
- Temperature at which measurement was made: 120°C
- Modification rate of an acid-modified cyclic polyolefin: integrated reduction rate of 3.42-3.94 ppm

(5) Transparency

Using an SE-180D injection molder made by Sumitomo Heavy Industries. Ltd., at a molding temperature of 220°C, and at a mold temperature of 40°C, 4cm x 8cm, 2 mm-thick flat sheets were made by injection molding. The HAZE measurement under JIS K7105 (1981) was made on the sheets obtained.

The HAZE values measured were used to evaluate the transparency. The results of the evaluation are shown in Table 1. Lower HAZE values mean better transparency.

(6) Heat resistance

The sheets obtained in item (5) above were divided into a plurality of groups each consisting of three of the sheets that are superposed one on top of another, and the Vicat softening temperature was measured for each group by the method described in JIS K7206 (1999). The Vicat softening temperatures measured were used to evaluate the heat resistance. The results of the evaluation are shown in Table 1. Higher Vicat softening temperatures mean higher heat resistance.

<Raw material>

- a-1: As the cyclic polyolefin (a), "TEFABLOC (registered trademark) CP MC930", made by Mitsubishi Chemical, which is hereinafter referred to as "a-1", was used.
- Crystal melting peak temperature: 75°C
- Dielectric loss tangent: 0.0003 (12GHz)
- Density (ASTM D792): 0.94 g/cm$^3$
- MFR (230°C, 2.16 kg): 1 g/10 minute
- Hydrogenated aromatic vinyl polymer block unit: 65 mole % hydrogenated polystyrene having a hydrogenation level of 99.5% or more
- Hydrogenated conjugated diene polymer block unit: 35 mole % hydrogenated polybutadiene having a hydrogenation level of 99.5% or more
- Block structure: pentablock structure having a total hydrogenation level of 99.5% or more

- a-2: As the modified cyclic polyolefin (a'), "TEFABLOC (registered trademark) CP MC940AP", made by Mitsubishi Chemical, which is hereinafter referred to as "a-2", was used.
- Crystal melting peak temperature: 75°C
- Dielectric loss tangent: 0.0009 (12GHz)
- Density (ASTM D792): 0.94 g/cm$^3$
- MFR (230°C, 2.16 kg): 3 g/10 minute
- Hydrogenated aromatic vinyl polymer block unit: 67 mole % hydrogenated polystyrene having a hydrogenation level of 99.5% or more
- Hydrogenated conjugated diene polymer block unit: 33 mole % hydrogenated polybutadiene having a hydrogenation level of 99.5% or more
- Block structure: pentablock structure having a total hydrogenation level of 99.5% or more
- Maleic acid modifying rate: 1.2% by mass
- Mw: 68000

- a-101: As a maleic acid-modified, hydrogenated styrene-butadiene block copolymer, "TUFTEC M1943" made by Asahi Kasei Corporation was used.

While a-101 is a maleic acid-modified polyolefin, because the aromatic vinyl polymer block unit of the polyolefin as the raw material of a-101 is not hydrogenated, it has no crystal melting peak temperature.

[Table 1]

| (Cyclic) polyolefin resin copolymer | | | a-1 | a-2 | a-101 |
|---|---|---|---|---|---|
| Physical properties | Modificatoin rate | mass % | 0 | 1.2 | 0.9 |
| | Hydrogenation level of hydrogenated aromatic vinyl polymer block units | % | >99.5 | >99.5 | 0 |
| | Hydrogenation level of hydrogenated conjugated diene polymer block units | % | >99.5 | >99.5 | >99 |
| | Mw | - | 76000 | 68000 | 100000 |
| Evaluation | Haze | % | 0.4 | 0.5 | 97 |
| | Vicat softening temperature | °C | 129 | 125 | 35 |

<<Test Example 2>>

In Test Example 2, the dielectric loss tangent, the storage elastic modulus, the flex resistance, and the haze were evaluated for each of the cases in which the resin sheet contains, or does not contain, a thermoplastic resin.

<Method of measurement>

(1) Dielectric properties

Using a cavity resonator method, the dielectric loss tangent of each resin sheet was measured in a direction into the sheet from its surface, and evaluated based on the following standards. Measurement was made at the frequency of 12 GHz.

[Evaluation standards]

A (good): The dielectric loss tangent is less than 0.005.
B (poor): The dielectric loss tangent is 0.005 or more.

(2) Storage elastic modulus

Using a viscoelastic spectrometer DVA-200 (made by IT Keisokuseigyo Kabushiki Kaisha), the dynamic viscoelasticity values of the resin sheets were measured under the following conditions. From the measurement results, the storage elastic modulus values at 24°C are indicated as the storage elastic modulus values of the respective resins, and were evaluated based on the following standards.

[Measurement conditions]

Frequency of oscillation: 10 Hz
Strain: 0.1%
Rate of temperature increase: 3°C/minute

Temperature range in which measurement was made: -50°C-200°C

[Evaluation standards]

A (good): The storage elastic modulus is less than 2000 MPa
B (poor): The storage elastic modulus is 2000 MPa or more

(3) Flex resistance

The folding strength values of the resin sheets were measured under JIS P8115, using an MIT folding endurance tester, to evaluate the flex resistance.

[Measurement conditions]

Flexing rate: 175 times/minute
Flexing angle: 135 degrees to the right and left respectively
Load: 9.8 N
Test direction: Longitudinal direction (MD) and width direction (TD) of the sheets formed

[Evaluation standards]

A (very good): Broken when flexed 300 times or more
B (good): Broken when flexed 10 times or more and less than 300 times
C: (poor): Broken when flexed less than 10 times

(4) Haze

Using a hazemeter, the total transmittance and diffused transmittance of each resin sheet were measured under JIS K7105. From the total transmittance and diffused transmittance obtained, the haze was calculated by the following formula, and evaluated based on the following standards.

$$\text{Haze (\%)} = [\text{diffused transmittance}]/[\text{total transmittance}] \times 100$$

[Evaluation standards]

A (very good): Haze is 5% or less
B (good): Haze is more than 5% and 10% or less
C (poor): Haze is more than 10%

<Raw materials>

[Cyclic polyolefin resin copolymers]

Cyclic polyolefin resin copolymers a-1 and a-2 of the above <<Test Example 1>> were used.

[Thermoplastic resins]

- b-1: Hydrogenated styrene-butadiene-styrene block copolymer (SEBS): dielectric loss tangent (12GHz) = 0.0004; storage elastic modulus (24°C) = 6.2 MPa; and density = 890 g/$cm^3$
- b-2: Linear low-density polyethylene (L-LDPE): dielectric loss tangent (12 GHz) = 0.0003; storage elastic modulus (24°C) = 290 MPa; and density = 920 g/$cm^3$
- b-3: Linear low-density polyethylene (L-LDPE): dielectric loss tangent (12 GHz) = 0.0003; storage elastic modulus (24°C) = 190 MPa; and density = 908 g/$cm^3$

<Example 1>

a-1, as the cyclic polyolefin resin copolymer, and b-1, as the thermoplastic resin, were melt-kneaded using a single-screw extruder, extruded through a T-die, and cooled and solidified by casting rolls, to form resin sheet A1-1 having a thickness of 100 μm. For the resin sheet A1-1 obtained, the storage elastic modulus, the dielectric loss tangent, the flex resistance and the haze were evaluated. The results of the evaluation are shown in Table 2.

<Examples 2-4>

Resin sheets A1-2 to A1-4 were each formed in the same manner as in Example 1, except that a cyclic polyolefin resin copolymer and a thermoplastic resin shown in Table 2 were added at the rate shown in Table 2, and melt-kneaded. For the thus-obtained resin sheets A1-2 to A1-4, the storage elastic modulus, the dielectric loss tangent, the flex resistance and the haze were evaluated. The results of the evaluation are shown in Table 2.

<Reference Example 1>

The cyclic polyolefin resin copolymer a-1 was used alone, and it was melt-kneaded using a single-screw extruder, extruded through a T-die, and cooled and solidified with casting rolls, to give a resin sheet A101 having a thickness of 100 μm. For the sheet obtained, the storage elastic modulus, the dielectric loss tangent, the flex resistance, and the haze were evaluated. The results of the evaluation are shown in Table 2.

[Table 2]

| | | | | Example 1 | Example 2 | Example 3 | Example 4 | Reference Example 1 |
|---|---|---|---|---|---|---|---|---|
| Content (mass %) | Cyclic polyolefin resin copolymer | a-1 | | 80 | 80 | - | - | - |
| | | a-2 | | - | - | 80 | 80 | 100 |
| | Thermoplastic resin | b-1 | | 20 | - | 20 | - | - |
| | | b-2 | | - | - | - | 20 | - |
| | | b-3 | | - | 20 | - | - | - |
| Evaluation | dielectric dissipation factor (12GHz) | - | | 0. 0004 | 0. 0004 | 0. 0008 | 0. 0007 | 0. 0009 |
| | | Evaluation | | A | A | A | A | A |
| | Storage elastic modulus | MPa | | 1500 | 1600 | 1500 | 1600 | 2000 |
| | | Evaluation | | A | A | A | A | B |
| | MIT test Number of times at break | Number of times | MD | 348 | 374 | 515 | 24 | Broken when flexed once |
| | | | TD | 544 | 357 | 445 | 12 | Broken when flexed once |
| | | Evaluation | | A | A | A | B | C |
| | Haze | % | | 1. 2 | 0. 8 | 1. 9 | 3. 5 | 0. 6 |
| | | Evaluation | | A | A | A | A | A |

Examples 1-4 and Reference Example 1 of Table 2 above confirm that the resin sheets containing the cyclic polyolefin resin copolymer of the present invention have low dielectric properties.

Also, Examples 1-4 show that by adding a particular thermoplastic resin to a cyclic polyolefin resin copolymer, flex resistance improves while maintaining low dielectric properties. Such resin sheets are less susceptible to breakage and cracks even if deflected. Thus, they can be easily wound onto a roll, or sheets can be formed easily by blanking, so that such sheets can be used as flexible printed circuit (FPC) board materials.

<<Test Example 3>>

In Test Example 3, the dielectric loss tangents and the linear thermal expansion coefficients were evaluated for resin sheets each forming a composite by including a glass cloth, and not forming a composite.

<Method of measurement>

(1) Dielectric properties

Using a cavity resonator method, the dielectric loss tangent of each resin sheet was measured in a direction into the sheet from its surface, and evaluated based on the following standards. Measurement was made at the frequency of 12 GHz.

[Evaluation standards]

A (good): The dielectric loss tangent is less than 0.005.
B (poor): The dielectric loss tangent is 0.005 or more.

(2) Linear thermal expansion coefficient

Test pieces, 3 mm wide and 10 mm long, were cut out from the respective resin sheets, and the linear thermal expansion coefficients of the test pieces were measured under JIS K7197, using TMA/SS7100 made by Hitachi High-Tech Science Corporation, for evaluation based on the following standards.

[Evaluation]

A (good): The average linear thermal expansion coefficient from 0°C to 100°C is less than 65 ppm/°C
B (poor): The average linear thermal expansion coefficient from 0°C to 100°C is 65 ppm/°C or more

<Raw material>

[Cyclic polyolefin resin copolymer]

Cyclic polyolefin resin copolymer a-2 of <<Test Example 1>> was used.

[Glass cloth]

- c-1: Quartz glass (made by Shin-Etsu Chemical Co., Ltd.; thickness: 50 μm, dielectric loss tangent: 0.0001 (10 GHz), linear thermal expansion coefficient: 0.5 ppm/°C)

<Example 5>

Cyclic polyolefin resin copolymer a-2 was melt-kneaded using an extruder, to form a resin sheet A2 having a thickness of 100 μm. The resin sheet A2 and the glass cloth c-1 were cut out to 10 cm square pieces, and two of the cut-out pieces of the resin sheet A2 were laminated on either side of a cut-out piece of the glass cloth c-1 such that their contents in volume would be as shown in Table 3. The laminate was sandwiched between two flat metal plates, and hot-pressed for 60 seconds at 200°C, and at the pressure of 20 MPa, to provide a resin composite A2-1. The resin composite A2-1 obtained was evaluated for its dielectric properties and linear thermal expansion coefficient. The results of the evaluation are shown in Table 3.

<Examples 6 and 7>

Except that the volumetric contents of the cyclic polyolefin resin copolymer a-2 and glass cloth c-1 are different as shown in Table 3, resin composites A2-2 and A2-3 were prepared in the same manner as in Example 5. The resin composites A2-2 and A2-3 obtained were evaluated for their dielectric properties and linear thermal expansion coefficients. The results of the evaluation are shown in Table 3.

<Reference Example 2>

The resin sheet A2 was evaluated for its dielectric properties and linear thermal expansion coefficient. The results of the evaluation are shown in Table 3.

[Table 3]

| | | | Example 5 | Example 6 | Example 7 | Reference Example 2 |
|---|---|---|---|---|---|---|
| Contents (volume %) | Cyclic polyolefin resin copolymer | a-2 | 95.3 | 91.0 | 83.5 | 100 |
| | Glass cloth | c-1 | 4.7 | 9.0 | 16.5 | 0 |
| Evaluation | dielectric dissipation factor (12GHz) | - | 0.0010 | 0.0010 | 0.0012 | 0.0009 |
| | | Evaluation | A | A | A | A |
| | Linear thermal expansion coefficient | ppm/℃ | 61 | 55 | 50 | 125 |
| | | Evaluation | A | A | A | B |

From Examples 5-7 of Table 3, it was confirmed that a composite of the cyclic polyolefin resin copolymer and the glass cloth, both according to the present invention, shows reduced liner thermal expansion coefficient, while maintaining low dielectric properties. By using such a resin composite as a circuit board material, it reduces curling and warping of the circuit board due to a difference in the thermal expansion coefficient between the resin composite and a metal layer, while maintaining low dielectric loss.

<<Test Example 4>>

In Test Example 4, for each of the cases (i) in which resin layers (A) which contain the cyclic polyolefin resin copolymer of the invention, and a resin layer (D) which contains the amorphous resin (d), were laminated together, and (ii) in which a single resin layer (A) was used alone, the dielectric loss tangent and the linear thermal expansion coefficient were evaluated. The results of the evaluation are shown in Table 3.

<Method of measurement>

(1) Dielectric properties

Using a cavity resonator method, the dielectric loss tangent, at 12 GHz, of each resin laminate in a direction into the laminate from its surface was measured, and evaluated based on the following standards.

[Evaluation standards]

A (good): The dielectric loss tangent is less than 0.005
B (poor): The dielectric loss tangent is 0.005 or more.

(2) Linear thermal expansion coefficient

Test pieces, 3 mm wide and 10 mm long, were cut out from the respective resin laminates, and the linear thermal expansion coefficients of the test pieces were measured under JIS K7197, using TMA/SS7100 made by Hitachi High-Tech Science Corporation, for evaluation based on the following standards.

[Evaluation standards]

A (good): The average linear thermal expansion coefficient from 0°C to 100°C is less than 115 ppm/°C
B (poor): The average linear thermal expansion coefficient from 0°C to 100°C is 115 ppm/°C or more

<Raw material>

[Cyclic polyolefin resin copolymer]

Cyclic polyolefin resin copolymer a-2 of <<Test Example 1>> above was used.

[Amorphous resin]

- d-1: Alicyclic olefin copolymer (COC) obtained by polymerizing norbornene-ethylene; dielectric loss tangent = 0.0002 (12 GHz), Tg = 138°C
- d-2: Polycarbonate; dielectric loss tangent = 0.0059 (12 GHz), Tg = 145°C
- d-3: Hydrogenated alicyclic olefin polymer (COP) obtained by subjecting cyclopentadiene to ring-opening polymerization; dielectric loss tangent = 0.0002 (12 GHz), Tg = 102°C
- d-4: Low-Tg alicyclic olefin copolymer (COC) obtained by polymerizing norbornene-ethylene; dielectric loss tangent = 0.0002 (12 GHz), Tg = 69°C

<Example 8>

Cyclic polyolefin resin copolymer a-2 as resin layers (A) and amorphous resin d-1 as a resin layer (D) were melt-kneaded separately using single-screw extruders, and coextruded through a T-die such that the resin layers (A) form front and back layers and the resin layer (D) forms an intermediate layer. They were then cooled and solidified with casting rolls to form a resin laminate having a thickness of 100 μm. The discharge rates of the respective extruders were adjusted such that the thickness ratio of the respective layers - resin layer (A)/resin layer (D)/resin layer (A) - will be 1/8/1. The resin laminate obtained were evaluated for its dielectric properties and linear thermal expansion coefficient. The results of the evaluation are shown in Table 4.

<Examples 9 and 10 and Reference Example 4>

In each of these examples, except that the kind and/or the content of the amorphous resin, and the lamination ratio were different, a resin laminate was formed in the same manner as in Example 8. The resin laminate obtained was evaluated for its dielectric properties and linear thermal expansion coefficient. The results of the evaluation are shown in Table 4.

<Reference Example 3>

Cyclic polyolefin resin copolymer a-2 was melt-kneaded using a single-screw extruder to form a 100 μm thick sheet. The sheet obtained was evaluated for its dielectric properties and linear thermal expansion coefficient. The results of the evaluation are shown in Table 4.

[Table 4]

| | | | Example 8 | Example 9 | Example 10 | Reference Example 3 | Reference Example 4 |
|---|---|---|---|---|---|---|---|
| Contents (mass %) | Resin layer (A) | | | | | | |
| | Cyclic polyolefin resin copolymer | a-2 | 100 | 100 | 100 | 100 | 100 |
| | Resin layer (D) | | | | | | |
| | Amorphous resin | d-1 | 100 | - | - | - | - |
| | | d-2 | - | - | 70 | - | - |
| | | d-3 | - | 100 | - | - | - |
| | | d-4 | - | - | - | - | 100 |
| | Cyclic polyolefin resin copolymer | a-2 | - | - | 30 | - | - |
| Lamination ratio (A/D/A) | | | 1/8/1 | 1/8/1 | 1/8/1 | single layer | 2/3/2 |
| Evaluation of laminates | dielectric dissipation factor (12GHz) | - | 0.0004 | 0.0006 | 0.0037 | 0.0009 | 0.0005 |
| | | Evaluation | 5 8 A | A | A | A | A |
| | Linear thermal expansion coefficient ppm/°C (0-100°C) | MD | 91 | 90 | 100 | 126 | 109 |
| | | TD | 85 | 98 | 113 | 128 | 162 |
| | | Evaluation | A | A | A | B | B |

Examples 8 - 10 of Table 4 demonstrate that, by laminating a resin layer (D) containing, as the amorphous resin (d), a resin that shows a predetermined dielectric loss tangent and glass transition point, on the resin layers (A), the linear thermal expansion coefficient decreases, while the dielectric properties of the cyclic polyolefin resin copolymer a-2 are maintained. By using such a resin laminate as, for example, an electric or electronic circuit board material, it is possible to reduce curling and warping of the circuit board due to a difference in shrinkage ratio between the resin laminate and a metal layer, while also reducing the dielectric loss.

## Claims

1. A resin sheet comprising at least a resin layer (A) containing a cyclic polyolefin resin copolymer having a crystal melting peak temperature of less than 100°C, the resin sheet having a dielectric loss tangent at 12 GHz of less than 0.005.

2. The resin sheet according to claim 1, wherein the cyclic polyolefin resin copolymer has cyclohexane in a side chain of the polyolefin.

3. The resin sheet according to claim 1 or 2, wherein the cyclic polyolefin resin copolymer is either: (i) a resin copolymer containing at least one hydrogenated aromatic vinyl polymer block unit, and at least one hydrogenated conjugated diene polymer block unit, or (ii) a modified copolymer obtained by modifying said resin copolymer with one or both of an unsaturated carboxylic acid and an anhydride of an unsaturated carboxylic acid.

4. The resin sheet according to claim 3, wherein a hydrogenation level of the hydrogenated aromatic vinyl polymer block unit is 90% or more.

5. The resin sheet according to claim 3 or 4, wherein a hydrogenation level of the hydrogenated conjugated diene polymer block unit is 95% or more.

6. The resin sheet according to any of claims 1-5, wherein the resin layer (A) contains at least one thermoplastic resin (b) selected from the group consisting of an ethylene-based polymer, olefin-based thermoplastic elastomer, and a styrene-based thermoplastic elastomer.

7. The resin sheet according to claim 6, wherein the resin sheet has a storage elastic modulus of less than 2000 MPa at 24°C.

8. The resin sheet according to any of claims 1-5, wherein the resin layer (A) is a composite including a glass cloth (C).

**9.** The resin sheet according to any of claims 1-5, wherein the resin sheet is a laminate including the resin layer (A) and a glass cloth (C).

**10.** The resin sheet according to claim 8 or 9, wherein the glass cloth (C) has a dielectric loss tangent of less than 0.005 at 10 GHz.

**11.** The resin sheet according to any of claims 1-5, wherein the resin sheet is a laminate including said resin layer (A), and an additional resin layer (D) containing an amorphous resin (d) having a glass transition point of 100°C or more, and a dielectric loss tangent of less than 0.02 at 12GHz.

**12.** The resin sheet according to claim 11, wherein the amorphous resin (d) comprises at least one of the resins selected from the group consisting of an alicyclic olefin polymer, a polycarbonate, a polyarylate, a polysulfone, and a copolymer thereof.

**13.** The resin sheet according to claim 11 or 12, wherein the resin layer (A) forms at least one of two outermost layers of the resin sheet.

**14.** The resin sheet according to any of claims 1-13, which is used for a circuit board.

**15.** A circuit board material comprising the resin sheet according to any of claims 1-13, and a conductor laminated on the resin sheet.

**INTERNATIONAL SEARCH REPORT**

International application No. PCT/JP2021/006316

A. CLASSIFICATION OF SUBJECT MATTER

Int.Cl. B32B5/10(2006.01)i, B32B27/32(2006.01)i, C08F8/04(2006.01)i, C08F8/46(2006.01)i, C08F297/04(2006.01)i, C08K7/14(2006.01)i, C08L23/00(2006.01)i, C08L53/02(2006.01)i, C08L67/03(2006.01)i, C08L69/00(2006.01)i, C08L81/06(2006.01)i, C08J5/18(2006.01)i, B32B15/08(2006.01)i, B32B7/025(2019.01)i, H05K1/03(2006.01)i

FI: C08L53/02, C08F297/04, C08K7/14, B32B5/10, H05K1/03610J, B32B15/08105Z, B32B7/025, H05K1/03630H, C08J5/18CEQ, C08F8/46, B32B27/32Z, C08F8/04, C08L23/00, C08L67/03, C08L69/00, C08L81/06

According to International Patent Classification (IPC) or to both national classification and IPC

B. FIELDS SEARCHED

Minimum documentation searched (classification system followed by classification symbols)

Int.Cl. B32B5/10, B32B27/32, C08F8/04, C08F8/46, C08F297/04, C08K7/14, C08L23/00, C08L53/02, C08L67/03, C08L69/00, C08L81/06, C08J5/18, B32B15/08, B32B7/025, H05K1/03

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2017-214525 A (HITACHI CHEMICAL COMPANY, LTD.) 07 December 2017 (2017-12-07), claims, examples, paragraph [0109] | 1-10, 14, 15<br>11-15 |
| X<br>Y | JP 2005-239851 A (ZEON CORPORATION) 08 September 2005 (2005-09-08), claims, paragraphs [0039], [0051] | 1-7, 14, 15<br>8-15 |

☒ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 06 April 2021 | 20 April 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/006316

C (Continuation). DOCUMENTS CONSIDERED TO BE RELEVANT

| Category* | Citation of document, with indication, where appropriate, of the relevant passages | Relevant to claim No. |
|---|---|---|
| X | JP 2017-159590 A (ZEON CORPORATION) 14 September 2017 (2017-09-14), claims, examples | 1-5, 11-13 |
| Y | JP 2011-001473 A (HITACHI CHEMICAL CO., LTD.) 06 January 2011 (2011-01-06), paragraph [0016] | 8-15 |
| Y | JP 2014-105291 A (ZEON CORPORATION) 09 June 2014 (2014-06-09), claims, paragraph [0004] | 8-15 |

Form PCT/ISA/210 (second sheet) (January 2015)

**INTERNATIONAL SEARCH REPORT**
Information on patent family members

International application No.
PCT/JP2021/006316

| | | |
|---|---|---|
| JP 2017-214525 A | 07 December 2017 | (Family: none) |
| JP 2005-239851 A | 08 September 2005 | (Family: none) |
| JP 2017-159590 A | 14 September 2017 | (Family: none) |
| JP 2011-001473 A | 06 January 2011 | (Family: none) |
| JP 2014-105291 A | 09 June 2014 | (Family: none) |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001006437 A
- WO 2012046443 A
- WO 2012033076 A


### Non-patent literature cited in the description


- *PHYSICS TODAY" of February 1999 under the subtitle of "Block Copolymers-Designer Soft Materials,* 32-38